# EUROPEAN PATENT APPLICATION

(11) **EP 4 692 991 A1**
(43) Date of publication of application: **11.02.2026**
(21) Application number: 24777949.9
(22) Date of filing: 25.03.2024
(51) Int. Cl.: G06F 3/01, G06F 18/10

(54) **HAPTIC SIGNAL ENCODING PROCESSING METHOD AND DECODING PROCESSING METHOD, AND RELATED DEVICE**

(30) Priority: 31.03.2023 CN 202310338779
(71) Applicant: Vivo Mobile Communication Co., Ltd., Dongguan, Guangdong 523863 (CN)
(72) Inventor: LV, Zhuoyi, Dongguan, Guangdong 523863 (CN); HE, Dazhong, Dongguan, Guangdong 523863 (CN)
(74) Representative: Lavoix
(86) International application number: PCT/CN2024/083452
(87) International publication number: WO 2024/199160

(57) **Abstract**

This application discloses a haptic signal encoding processing method, a haptic signal decoding processing method, and a related device, and pertains to the haptic encoding and decoding field. The haptic signal encoding processing method in embodiments of this application includes: obtaining at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained based on the haptic signal, and a frequency of the second signal is less than a frequency of the third signal; and performing at least one of the following: performing first masking processing on the key frame sequence based on a first masking model, and encoding a signal obtained through the first masking processing, to obtain a first encoded sequence; and performing second masking processing on the first signal based on a second masking model, and encoding a signal obtained through the second masking processing, to obtain a second encoded sequence.

## Description

### CROSS-REFERENCE TO RELATED APPLICATIONS

This application claims priority to Chinese Patent Application No. 202310338779.7, filed in China on March 31, 2023, which is incorporated herein by reference in its entirety.

### TECHNICAL FIELD

This application pertains to the field of haptic encoding and decoding technologies, and specifically relates to a haptic signal encoding processing method, a haptic signal decoding processing method, and a related device.

### BACKGROUND

In a haptic signal (the haptic signal includes but is not limited to a vibration texture perceptual signal) encoding process, usually, a plurality of single-point haptic signals are encoded one by one, to implement multi-point haptic signal encoding. However, in the encoding process, because of a masking effect between adjacent haptic signals, there is information redundancy if haptic signals are obtained by encoding the single-point haptic signals one by one. Therefore, a problem that a compression rate of a haptic signal is relatively low exists in the prior art.

### SUMMARY

Embodiments of this application provide a haptic signal encoding processing method, a haptic signal decoding processing method, and a related device, to resolve a problem that a compression rate of a haptic signal is relatively low.

According to a first aspect, a haptic signal encoding processing method is provided, applied to an encoder side, and including:
obtaining at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and
performing a target operation, where the target operation includes at least one of the following:
   performing first masking processing on the key frame sequence based on a first masking model, and encoding a signal obtained through the first masking processing, to obtain a first encoded sequence; and
   performing second masking processing on the first signal based on a second masking model, and encoding a signal obtained through the second masking processing, to obtain a second encoded sequence.

According to a second aspect, a haptic signal decoding processing method is provided, applied to a decoder side, and including:
decoding a second encoded sequence, to obtain a plurality of paths of fourth signals;
performing block processing on each path of fourth signal, to obtain at least one signal block, where each signal block corresponds to one time interval;
determining a primary signal block and a secondary signal block that correspond to each time interval;
unmasking the secondary signal block based on the primary signal block for each time interval, to obtain a fifth signal, where the fifth signal includes the primary signal block and an unmasked secondary signal block; and
obtaining a plurality of paths of decoded signals based on the fifth signal, where
the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

According to a third aspect, a haptic signal encoding processing apparatus is provided, applied to an encoder side, and including:
an obtaining module, configured to obtain at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and
an execution module, configured to perform a target operation, where the target operation includes at least one of the following:
   performing first masking processing on the key frame sequence based on a first masking model, and encoding a signal obtained through the first masking processing, to obtain a first encoded sequence; and
   performing second masking processing on the first signal based on a second masking model, and encoding a signal obtained through the second masking processing, to obtain a second encoded sequence.

According to a fourth aspect, a haptic signal decoding processing apparatus is provided, applied to a decoder side, and including:
a decoding module, configured to decode a second encoded sequence, to obtain a plurality of paths of fourth signals;
a block processing module, configured to perform block processing on each path of fourth signal, to obtain at least one signal block, where each signal block corresponds to one time interval;
a first determining module, configured to determine a primary signal block and a secondary signal block that correspond to each time interval;
a restoration module, configured to unmask the secondary signal block based on the primary signal block for each time interval, to obtain a fifth signal, where the fifth signal includes the primary signal block and an unmasked secondary signal block; and
a processing module, configured to obtain a plurality of paths of decoded signals based on the fifth signal, where
the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

According to a fifth aspect, an electronic device is provided. The electronic device includes a processor and a memory, the memory stores a program or instructions capable of running on the processor, and when the program or the instructions are executed by the processor, the steps of the method according to the first aspect are implemented, or when the program or the instructions are executed by the processor, the steps of the method according to the second aspect are implemented.

According to a sixth aspect, an electronic device is provided, including a processor and a communication interface.

When the electronic device is an encoder side, the processor is configured to: obtain at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and perform a target operation, where the target operation includes at least one of the following: performing first masking processing on the key frame sequence based on a first masking model, and encoding a signal obtained through the first masking processing, to obtain a first encoded sequence; and performing second masking processing on the first signal based on a second masking model, and encoding a signal obtained through the second masking processing, to obtain a second encoded sequence.

When the electronic device is a decoder side, the processor is configured to: decode a second encoded sequence, to obtain a plurality of paths of fourth signals; perform block processing on each path of fourth signal, to obtain at least one signal block, where each signal block corresponds to one time interval; determine a primary signal block and a secondary signal block that correspond to each time interval; unmask the secondary signal block based on the primary signal block for each time interval, to obtain a fifth signal, where the fifth signal includes the primary signal block and an unmasked secondary signal block; and obtain a plurality of paths of decoded signals based on the fifth signal, where the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

According to a seventh aspect, a haptic signal encoding and decoding system is provided, including an encoder side device and a decoder side device. The encoder side device may be configured to perform the steps of the haptic signal encoding processing method according to the first aspect, and the decoder side device may be configured to perform the steps of the haptic signal decoding processing method according to the second aspect.

According to an eighth aspect, a readable storage medium is provided. The readable storage medium stores a program or instructions, and when the program or the instructions are executed by a processor, the steps of the method according to the first aspect are implemented, or the steps of the method according to the second aspect are implemented.

According to a ninth aspect, a chip is provided. The chip includes a processor and a communication interface, the communication interface is coupled to the processor, and the processor is configured to run a program or instructions to implement the steps of the method according to the first aspect or implement the steps of the method according to the second aspect.

According to a tenth aspect, a computer program/program product is provided. The computer program/program product is stored in a storage medium. The computer program/program product is executed by at least one processor, to implement the steps of the method according to the first aspect or implement the steps of the method according to the second aspect.

In the embodiments of this application, at least one of a key frame sequence or a first signal that correspond to each of a plurality of paths of haptic signals is obtained. The key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal. A target operation is performed. The target operation includes at least one of the following: performing first masking processing on the key frame sequence based on a first masking model, and encoding a signal obtained through the first masking processing, to obtain a first encoded sequence; and performing second masking processing on the first signal based on a second masking model, and encoding a signal obtained through the second masking processing, to obtain a second encoded sequence. In this way, because masking processing is performed on at least one of the key frame sequence or the first signal, signal redundancy can be removed, to improve compression efficiency of the haptic signal.

### BRIEF DESCRIPTION OF DRAWINGS

FIG. 1 is a schematic flowchart of a haptic signal encoding processing method according to an embodiment of this application;
FIG. 2 is a schematic diagram of an encoding framework of a haptic signal encoding processing method according to an embodiment of this application;
FIG. 3 is a schematic flowchart of a haptic signal decoding processing method according to an embodiment of this application;
FIG. 4 is a schematic diagram of a decoding framework of a haptic signal decoding processing method according to an embodiment of this application;
FIG. 5 is a schematic structural diagram of a haptic signal encoding processing apparatus according to an embodiment of this application;
FIG. 6 is a schematic structural diagram of a haptic signal decoding processing apparatus according to an embodiment of this application;
FIG. 7 is a structural diagram of a communication device according to an embodiment of this application; and
FIG. 8 is a structural diagram of an electronic device according to an embodiment of this application.

### DESCRIPTION OF EMBODIMENTS

The following clearly describes technical solutions in embodiments of this application with reference to accompanying drawings in the embodiments of this application. Clearly, the described embodiments are merely some rather than all of the embodiments of this application. All other embodiments obtained by a person of ordinary skill in the art based on embodiments of this application shall fall within the protection scope of this application.

The terms "first", "second", and the like in this application are used to distinguish between similar objects instead of describing a specified order or sequence. It should be understood that, terms used in this way are interchangeable under appropriate circumstances, so that embodiments of this application can be implemented in a sequence other than that illustrated or described herein. Moreover, the terms "first" and "second" typically distinguish between objects of one category rather than limiting a quantity of objects. For example, there can be one or more first objects. In addition, "or" in this application represents at least one of connected objects. For example, "A or B" includes three solutions, that is, solution 1: including A and not including B; solution 2: including B and not including A; and solution 3: including both A and B. The character "/" generally represents an "or" relationship between associated objects.

The term "indication" in this application may be either a direct indication (or an explicit indication) or an indirect indication (or an implicit indication). The direct indication may be understood as: A sender explicitly notifies, in a sent indication, a receiver of specific information, an operation that needs to be performed, a requested result, or other content. The indirect indication may be understood as: The receiver determines corresponding information based on the indication sent by the sender, or performs determining based on the indication sent by the sender, and determines, based on a determining result, the operation that needs to be performed or the requested result.

An encoder/decoder side corresponding to a haptic signal encoding/decoding method in embodiments of this application may be a terminal. The terminal may also be referred to as a terminal device or user equipment (UE). The terminal may be a mobile phone, a tablet computer (Tablet Personal Computer), a laptop computer (Laptop Computer) that is alternatively referred to as a notebook computer, a personal digital assistant (PDA), a palm computer, a netbook, an ultra-mobile personal computer (UMPC), a mobile internet device (MID), a wearable device (Wearable Device), vehicle user equipment (VUE), pedestrian user equipment (PUE), or another terminal side device. The wearable device includes a smart watch, a wristband, a headset, glasses, and the like. It should be noted that a specific type of the terminal is not limited in the embodiments of this application.

For ease of understanding, the following describes some content related to the embodiments of this application.

As a unique sensory channel of a human body, haptics enables effectively obtaining of complex information that is difficult to be perceived in another perceptual form, for example, through vision or audition. Haptic information means perception of a shape, a position, a surface texture, an object rigidity degree, a roughness degree, a temperature, and the like by the human body, and is mainly classified into two types: kinesthesia-based haptic information (briefly referred to as kinesthetic information below) and haptic information based on cutaneous texture perception (briefly referred to as texture perceptual information below). An object surface texture, a friction force, a temperature, and the like perceived by a cutaneous mechanoreceptor are all texture perceptual information. After hardware system collection and texture perceptual encoding, a texture perceptual signal is reconstructed by a specific haptic reproduction device, and a combination of vibration or a stimulation pulse that are perceived by the receptor is transmitted to a user. For example, a new haptic feedback display allows a finger to slide on a touchscreen to experience a texture haptic sense. A vibration wave haptic feedback disk adds vibration haptic perception to an audiovisual sense of an existing virtual reality game. Google (Google) adds a haptic game handle to a game platform. Development of these haptic reconstruction systems is inseparable from a texture perceptual encoding technology. The texture perceptual encoding technology is an important basis for developing these devices.

Texture perceptual encoding methods mainly include three types: a statistics-based encoding method, a perceptual model (Weber theorem)-based encoding method, and a hybrid perceptual encoding method. Statistics-based texture perceptual encoding reduces data redundancy by using quantization and prediction models. The perceptual model-based encoding method implements data compression by setting a difference threshold (authentication sensitivity). Hybrid perceptual encoding extracts a necessary attribute of an input signal based on a perceived absolute threshold and masking phenomenon, to implement perceptual compression. In a perceptual vibrotactile-signal compression algorithm (PVC-SLP) based on sparse linear prediction, a haptic sensitivity model is constructed based on an acceleration sensitivity function (ASF), which is currently selected as part of the IEEE P1918.1.1 haptic encoding and decoding standard.

With reference to the accompanying drawings, the following describes in detail a haptic signal encoding processing method provided in embodiments of this application by using some embodiments and application scenarios thereof.

Step 101: Obtain at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal.

In this embodiment of this application, each path of haptic signal corresponds to the key frame sequence and the first signal. The second signal may be understood as a low-frequency signal component of the haptic signal, and the third signal may be understood as a high-frequency signal component of the haptic signal.

Optionally, in some embodiments, a plurality of paths of spatially adjacent haptic signals and spatial information of the haptic signal may be first obtained. The spatial information includes but is not limited to the following information: body area information, position information in a body area, and relative position information of all signal sources. Then, the key frame sequence and the first signal that correspond to each path of haptic signal may be obtained by using the following procedure:
performing low-pass filtering processing on the plurality of paths of haptic signals, and separating the low-frequency signal component and the high-frequency signal component that are easily perceived by a human body, to obtain the second signal and the third signal;
using each signal extreme value of each path of second signal as a key frame, to obtain a key frame sequence corresponding to each path of second haptic signal;
obtaining a reconstructed low-frequency signal through interpolation and reconstruction, and calculating a residual between the reconstructed low-frequency signal and the corresponding second signal, to obtain the target residual signal;
adding the target residual signal to the corresponding third signal, to obtain the first signal, that is, to obtain a high-frequency signal with a low-frequency residual.

Step 102: Perform a target operation, where the target operation includes at least one of the following:
performing first masking processing on the key frame sequence based on a first masking model, and encoding a signal obtained through the first masking processing, to obtain a first encoded sequence; and
performing second masking processing on the first signal based on a second masking model, and encoding a signal obtained through the second masking processing, to obtain a second encoded sequence.

In this embodiment of this application, a masking manner may be selected according to a requirement. For example, only the key frame sequence may be masked, only the first signal may be masked, or both the key frame sequence and the first signal may be masked. It should be understood that, when the key frame sequence or the first signal is not masked, it may be understood that conventional encoding processing is not performed on a masked object.

Optionally, the first masking model includes but is not limited to a space-time joint masking effect model applicable to a low-frequency signal. The second masking model includes but is not limited to a space-time joint masking effect model applicable to a high-frequency signal. The time-space joint masking effect model represents a masking effect of primary signals of different frequencies on a surrounding secondary signal under an action of the primary signal, which is represented by a masking threshold coefficient. An amplitude of the primary signal is multiplied by the masking threshold coefficient, and a masking threshold matrix may be obtained through a corresponding assignment operation. When an amplitude of spatially adjacent secondary signals around the primary signal is lower than a masking threshold, it indicates that the primary signal produces a masking effect on the secondary signal, and a human cannot feel or find it very difficult to feel the secondary signal under impact of the primary signal.

In the embodiments of this application, at least one of the key frame sequence or the first signal that correspond to each of the plurality of paths of haptic signals is obtained. The key frame sequence is obtained based on the second signal, the first signal is obtained based on the target residual signal and the third signal, the target residual signal is obtained based on the second signal and the key frame sequence, the second signal and the third signal are obtained by performing low-pass filtering processing on the haptic signal, and the frequency of the second signal is less than the frequency of the third signal. The target operation is performed. The target operation includes at least one of the following: performing first masking processing on the key frame sequence based on the first masking model, and encoding the signal obtained through the first masking processing, to obtain the first encoded sequence; and performing second masking processing on the first signal based on the second masking model, and encoding the signal obtained through the second masking processing, to obtain the second encoded sequence. In this way, because masking processing is performed on at least one of the key frame sequence or the first signal, signal redundancy can be removed, to improve compression efficiency of the haptic signal.

Optionally, in some embodiments, the performing first masking processing on the key frame sequence based on a first masking model, to obtain a first encoded sequence includes:
determining a primary key frame sequence and a secondary key frame sequence from the key frame sequences corresponding to the plurality of paths of haptic signals;
determining the first masking model based on spatial position information corresponding to the primary key frame sequence and spatial position information corresponding to the secondary key frame sequence;
performing first masking processing on the secondary key frame sequence based on the first masking model, to obtain a target key frame sequence, where the target key frame sequence includes the primary key frame sequence and a masked secondary key frame sequence; and
encoding the target key frame sequence, to obtain the first encoded sequence.

In this embodiment of this application, the first encoded sequence may be referred to as a low-frequency encoded sequence. The primary key frame sequence may be understood as a key frame sequence corresponding to a haptic signal of a haptically sensitive point, or may be understood as a key frame sequence corresponding to a haptic signal with a relatively high signal strength. The secondary key frame sequence is a key frame sequence other than the primary key frame sequence in a plurality of key frame sequences corresponding to a plurality of haptic signals. In other words, in this embodiment of this application, the primary key frame sequence meets at least one of the following:
the primary key frame sequence is a key frame sequence corresponding to a haptic signal of a haptically sensitive point; and
the primary key frame sequence is a key frame sequence corresponding to a haptic signal whose signal strength is greater than or equal to a preset strength threshold.

Optionally, a method for determining the primary key frame sequence may include the following methods:
1. When signal strengths are approximately the same, the primary key frame sequence is determined based on whether a position of a haptic signal is a haptically sensitive point. For example, the key frame sequence corresponding to the haptic signal of the haptically sensitive point is used as the primary key frame sequence. The haptically sensitive point may be obtained through a subjective test, or may be defined based on a specific device and a specific part.
2. When there is a relatively large difference between signal strengths, the primary key frame sequence and the secondary key frame sequence may be defined based on the signal strength. For example, a specified time interval may be first determined, and a key frame included in the time interval is interpolated to obtain a restored signal.

An integration operation is performed on all paths of restored signals based on factors such as an amplitude and a power, descending sorting is performed based on an integration result, and several key frame sequences are selected according to a compression requirement and are defined as primary key frame sequences.

It should be understood that different spatial position information corresponds to different masking models, and the corresponding first masking model may be selected based on position information of the key frame sequence, to perform masking processing. For example, a face area corresponds to one masking model, and a finger area corresponds to one masking model.

Optionally, there may be one or more primary key frame sequences, and each primary key frame sequence is a key frame sequence corresponding to one path of haptic signal.

Optionally, the performing first masking processing on the secondary key frame sequence based on the first masking model may include the following procedure:
deleting, based on a masking threshold and a masking point quantity, a key frame less than the masking threshold in the secondary key frame sequence in a distance range corresponding to a masking point quantity of the key frame in the primary key frame sequence.

Optionally, the target key frame sequence may be understood as a masked key frame sequence, and binary encoding may be performed when the target key frame sequence is encoded. An encoding length may be set according to an actual requirement. For example, the encoding length may be 8, 16, or 32.

Optionally, in some embodiments, the performing first masking processing on the secondary key frame sequence based on the first masking model, to obtain a target key frame sequence includes:
inputting a frequency of the primary key frame sequence into the first masking model, to obtain a first masking threshold coefficient;
multiplying an amplitude of the primary key frame sequence by the first masking threshold coefficient, to obtain a first masking threshold matrix; and
performing first masking processing on the secondary key frame sequence based on the first masking threshold matrix, to obtain the target key frame sequence.

In this embodiment of this application, the performing first masking processing on the secondary key frame sequence based on the first masking threshold matrix may be: comparing an amplitude of each key frame in the secondary key frame sequence and a masking threshold of a corresponding position of each key frame in the first masking threshold matrix; and when the amplitude of each key frame is less than the masking threshold of the corresponding position of the key frame in the first masking threshold matrix, setting the amplitude of the key frame to 0 or deleting the secondary key frame (in this case, the key frame may be understood as a redundant signal). In other words, the first masking processing includes: when an amplitude of a target secondary key frame in the secondary key frame sequence is less than or equal to a masking threshold corresponding to the target secondary key frame in the first masking threshold matrix, setting the amplitude of the target secondary key frame to 0 or deleting the target secondary key frame. One masking threshold of one position in one first masking threshold matrix corresponds to positions in one interval range. For example, a masking threshold of a position 300 (it is assumed that a 300th signal frame is a primary key frame, and the position 300 is a position of the 300th signal frame in the first masking threshold matrix) corresponds to a position 300 (a 301st signal frame in the secondary signal sequence) to a position 328 (the 301st signal frame in the secondary signal sequence). That is, a second key frame included in signal frames corresponding to the position 301 to the position 328 corresponds to the masking threshold of the position 300.

Optionally, in some embodiments, the performing second masking processing on the first signal based on a second masking model, and encoding a signal obtained through the second masking processing, to obtain a second encoded sequence includes:
performing block processing on each path of first signal, to obtain at least one signal block, where each signal block corresponds to one time interval;
determining a primary signal block and a secondary signal block for a signal block in each time interval;
determining the second masking model based on a spatial-modal mask;
performing second masking processing on the secondary signal block based on the second masking model, to obtain target signal blocks corresponding to each time interval, where the target signal blocks include the primary signal block and a masked secondary signal block;
splicing the target signal blocks corresponding to all time intervals based on a correspondence between a signal block and the haptic signal, to obtain a plurality of paths of to-be-encoded signals; and
performing encoding processing on the plurality of paths of to-be-encoded signals, to obtain the second encoded sequence.

The spatial-modal mask is determined based on a relative position between the primary signal block and the secondary signal block.

In this embodiment of this application, each path of haptic signal corresponds to one path of first signal. A specific block length may be set according to an actual requirement, and the block length does not directly affect a compression effect of the haptic signal. However, the block length affects second masking processing, and indirectly affects the compression effect. Therefore, the block length may be understood as a hyper-parameter, and may be set based on an actual situation such as processing performance and a compression effect requirement of a haptic processing device. For example, in some embodiments, the block length may be 32, 64, 128, 512, or the like. It should be noted that, if a compression fidelity requirement and a device processing capability requirement are met, a relatively large value may be selected as far as possible, to improve a compression rate of the haptic signal.

Optionally, when block processing is performed to obtain at least two signal blocks, each path of signal in each path of signal block is a part of signals in one path of first signal. For example, if the first signal includes 1024 frames of signals, and the block length is 512, two signal blocks are obtained through block processing, a first signal block includes a 1st frame of signal to a 512nd frame of signal, and a second signal block includes a 513rd frame of signal to a 1024th frame of signal.

It should be understood that a same time interval exists when block processing is performed on different paths of first signals. In other words, a specific time interval includes one signal block of each path of first signal. Optionally, in this embodiment of this application, a primary signal block in each time interval may be determined based on an agreed algorithm, and there may be one or more primary signal blocks corresponding to one time interval. This is not further limited herein. The primary signal block needs to be a signal with a relatively large strength indicator such as an amplitude in a current time interval or a signal for which the human body has a relatively sensitive feeling. Because of existence of a primary signal in the primary signal block and retention of haptic perception of the human body, the primary signal in the primary signal block produces a spatial masking effect on a secondary signal in another relatively weak secondary signal block at a spatially adjacent position of the primary signal block in a specific time period. The spatial masking effect makes it difficult for the human body to haptically perceive these masked secondary signals. Existence of these secondary signals has relatively low significance for reproduction of a haptic signal that can be perceived by the human body, and may be referred to as redundant haptic information. Removing the redundant haptic information exerts little impact on signal fidelity. Removing a large amount of redundant information may significantly improve compression performance.

Optionally, in this embodiment of this application, a signal in the primary signal block may be referred to as a primary signal, and a signal in the secondary signal block may be referred to as a secondary signal.

Optionally, the agreed algorithm may be set according to an actual requirement. The following describes some possible solutions:
1. When signal strengths are approximately the same, the primary signal block is determined based on whether a position of a haptic signal is a haptically sensitive point. An input signal (namely, a signal block of the first signal) corresponding to a haptic signal of the haptically sensitive point is used as a primary signal block. The haptically sensitive point may be obtained through a subjective test, or may be defined based on a specific device and a specific part.
2. When a signal strength has relatively large interpolation, the primary signal block and the secondary signal block may be defined based on the signal strength. For all input signals (namely, the signal block of the first signal), an integration operation is performed on all block signals input on a plurality of paths based on factors such as an amplitude and a power, descending sorting is performed based on an integration result, and several signal blocks are selected based on a compression requirement and are defined as primary signal blocks.

Optionally, in the subjective test, it is usually difficult to test a masking effect of primary signal blocks at all frequencies, and only several primary signal blocks with a controlled frequency value are selected for a spatial masking effect test. Therefore, when the time-space joint masking effect model is obtained through the subjective test, a second masking threshold coefficient of a masking effect of a primary signal block at any frequency needs to be obtained based on an interpolation function.

It should be noted that in this embodiment of this application, a second masking processing procedure may be performed for one time interval each time (the second masking processing procedure includes: determining the primary signal block and the secondary signal block, determining the second masking model, and finally performing second masking processing), and then the second masking processing procedure is cyclically performed to obtain the target signal blocks corresponding to each time period.

Optionally, in some embodiments, one primary signal block includes K primary signals, K is a positive integer, and the performing second masking processing on the secondary signal block based on the second masking model, to obtain target signal blocks corresponding to each time interval includes:
inputting a characteristic frequency of the primary signal block into the second masking model, to obtain a second masking threshold coefficient;
multiplying an amplitude of the primary signal block by the second masking threshold coefficient, to obtain a second masking threshold matrix;
performing assignment processing on the second masking threshold matrix based on the K primary signals, to obtain a third masking threshold matrix; and
performing second masking processing on the secondary signal block based on the third masking threshold matrix, to obtain the target signal blocks.

The assignment processing meets: performing assignment processing when the K primary signals include at least one unprocessed primary signal; and during a Pth time of assignment processing, assigning a masking threshold of a first position to masking thresholds of n consecutive second positions located after the first position in the second masking threshold matrix, where the first position is adjacent to the n second positions, the first position is a position corresponding to a primary signal with a largest amplitude in an unprocessed primary signal during first (P-1)th times of assignment processing, and a primary signal corresponding to the first position and a primary signal corresponding to the second position are primary signals processed during the Pth time of assignment processing, and both n and P are positive integers.

In this embodiment of this application, each primary signal block corresponds to one second masking threshold matrix. When a plurality of primary signal blocks exist, same processing is performed for each primary signal block. Details are not described herein again. One primary signal block is used as an example for description: During a 1st time of assignment processing, the K primary signals may be sorted to obtain a primary signal with a largest amplitude in the K primary signals, a first position corresponding to the primary signal with the largest amplitude in the K primary signals in the second masking threshold matrix is determined, the masking threshold of the first position is assigned to the masking thresholds of the n consecutive second positions located after the first position in the second masking threshold matrix, and a primary signal corresponding to the first position and a primary signal corresponding to the n consecutive second positions are marked as processed primary signals. During a 2nd time of assignment processing, Q primary signals (namely, unprocessed primary signals in the K primary signals) may be sorted to obtain a primary signal with a largest amplitude in the Q primary signals, a first position corresponding to the primary signal with the largest amplitude in the Q primary signals in the second masking threshold matrix is determined, the masking threshold of the first position is assigned to the masking thresholds of the n consecutive second positions located after the first position in the second masking threshold matrix, and a primary signal corresponding to the first position and a primary signal corresponding to the n consecutive second positions are marked as processed primary signals. This is cyclically performed until all primary signals are processed.

Optionally, the unprocessed primary signal may be understood as a primary signal in the K primary signals other than the primary signal corresponding to the first position and the primary signal corresponding to the second position.

For example, that the block length is equal to 1024, and n=128 is used as an example. It is assumed that the position corresponding to the primary signal with the largest amplitude is determined as 300 during the first time of assignment processing. In this case, a position 301 to a position 428 in the second masking threshold matrix may be assigned based on a masking threshold of the position 300. During the 2nd time of assignment processing, the primary signal with the largest amplitude is found in primary signal corresponding to all positions other than the position 300 to the position 428, and then a corresponding position in the second masking threshold matrix continues to be assigned. For example, it is assumed that the position corresponding to the primary signal with the largest amplitude is determined as 200 during the 2nd time of assignment processing. In this case, a position 201 to a position 328 in the second masking threshold matrix may be assigned based on a masking threshold of the position 200.

It should be noted that, in some embodiments, during assignment, a position corresponding to a processed primary signal may be excluded. For example, during the 2nd time of assignment processing in the foregoing embodiment, the position 201 to a position 299 in the second masking threshold matrix may be assigned based on the masking threshold of the position 200. It should be understood that because the masking threshold of the position 300 during the 1st time of assignment processing is greater than the masking threshold of the position 200 during the 2nd time of assignment processing (because an original primary signal corresponding to the position 300 is greater than an original primary signal corresponding to the position 200, the masking threshold of the position 300 is greater than the masking threshold of the position 200 after being multiplied by a same threshold coefficient), the value assigned to the position 300 to the position 328 during the 2nd time of assignment processing is overwritten by the larger assigned value during the 1st time of assignment processing.

Optionally, in some embodiments, the second masking processing includes at least one of the following:
when an amplitude of a first secondary signal in an Lth secondary signal block is 0, keeping the amplitude of the first secondary signal unchanged, and adding a first flag to metadata, where the first flag is used to indicate that the first secondary signal does not need to be unmasked; and
when an amplitude of a second secondary signal in the Lth secondary signal block is not 0, setting the amplitude of the second secondary signal to 0, and adding a second flag to the metadata, where the second flag is used to indicate that the second secondary signal needs to be unmasked.

L is a positive integer.

It should be noted that, a decoder side may determine, based on the second flag, a second secondary signal that needs to be restored (the decoder side learns that an amplitude of the second secondary signal is 0), and replace the amplitude of the second secondary signal with M times of a primary signal, to obtain an unmasked second secondary signal. For example, the decoder side learns that an amplitude of a secondary signal in the Lth secondary signal block is 0, and it is determined, based on the second flag, that the secondary signal needs to be unmasked. If a second masking threshold coefficient corresponding to the secondary signal is 0.5 and a corresponding proportionality coefficient is 0.8, the decoder side may replace the secondary signal in the Lth secondary signal block with a primary signal waveform whose amplitude is 0.5*0.8=0.4 times the amplitude of the primary signal.

Optionally, a rule for determining the proportionality coefficient may include but is not limited to any one of the following:
1. A same proportionality coefficient is used for all secondary signal blocks, and is determined based on a ratio of an average amplitude of masked secondary signals to a secondary average amplitude of primary signals corresponding to the masked secondary signals.
2. Different proportionality coefficients are used for each secondary signal block, and are determined based on a ratio of an average amplitude of masked secondary signals of each secondary signal block to an average amplitude of a primary signal block corresponding to the secondary signal block.

Optionally, after all paths of masked high-frequency block signals (namely, the target signal blocks) are obtained, a signal combination may be performed to obtain a plurality of paths of new high-frequency haptic signals (namely, a plurality of paths of signals obtained through splicing). In this case, the plurality of paths of high-frequency haptic signals are signals obtained through de-redundancy processing based on the spatial masking effect and a retention principle of the masking effect in time. Compared with the first signal, in the signals, a large quantity of haptic signals that cannot be perceived or are very difficult to be perceived by the human body due to the spatial masking effect are reduced, and a haptic perceptual difference of the human body on the processed signal is basically ensured.

Optionally, in some embodiments, the method further includes:
performing a fast Fourier transform (FFT) operation on the primary signal block, to obtain a spectrum of the primary signal block; and
determining a frequency component with a largest amplitude in the spectrum of the primary signal block as the characteristic frequency of the primary signal block.

Optionally, in some embodiments, the method further includes:
sending the metadata (Metadata) to a decoder side, where the metadata includes at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

In this embodiment of this application, the metadata describes data, is mainly information that describes a data attribute, and is indispensable in signal encoding and decoding. The metadata also needs to be transmitted in encoding and decoding of a vibration haptic signal, so that the decoder side restores an original vibration haptic signal.

Optionally, in some embodiments, the metadata may further include: body area information of all signals, position information in a body area, and relative position information between all the signals. When the haptic signal is a vibration haptic signal, the metadata may further include other information such as a sampling rate of the vibration haptic signal.

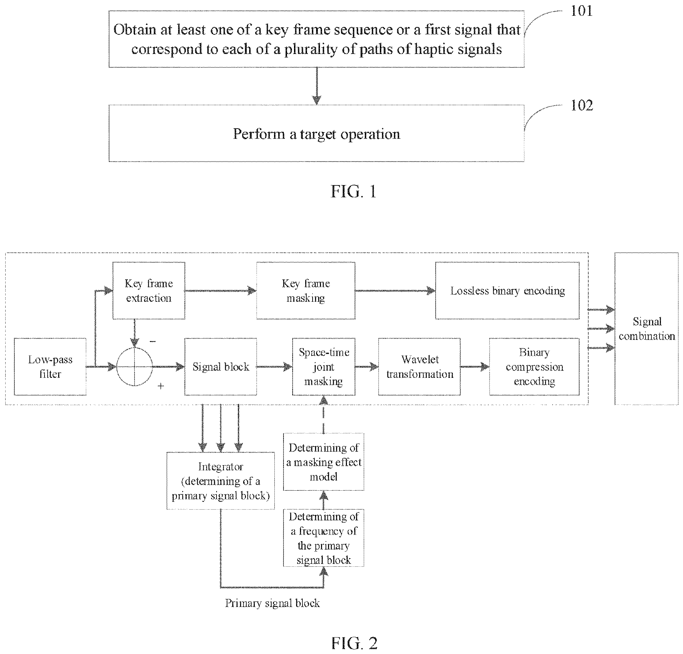

To better understand this application, the following describes an encoding procedure in this application with reference to FIG. 2. As shown in FIG. 2, an encoding processing procedure for each path of haptic signal may include the following steps:
21: Perform low-pass filtering processing on the haptic signal, to obtain a second signal (a low-frequency signal component) and a third signal (a high-frequency signal component).
22: Perform key frame extraction on the second signal to obtain a key frame sequence, perform key frame masking (namely, first masking processing) on the key frame sequence to obtain a target key frame sequence, and perform lossless binary encoding on the target key frame sequence to obtain a first encoded sequence.
23: Reconstruct a low-frequency signal based on the key frame sequence, calculate a residual between the reconstructed low-frequency signal and the original second signal to obtain a target residual signal, and add the target residual signal to the third signal to obtain a first signal (a high-frequency signal with a low-frequency residual).
24: Perform block processing on the first signal, determine a primary signal block based on an integrator, determine a characteristic frequency of the primary signal block, and determine a time-space joint masking effect model based on the characteristic frequency.
25: Perform time-space joint masking on a secondary signal block of the first signal by using the time-space joint masking effect model, and then perform wavelet transformation and binary compression encoding.
26: Perform signal combination on an encoded sequence obtained by compressing and encoding a plurality of signals, to obtain a final encoded sequence.

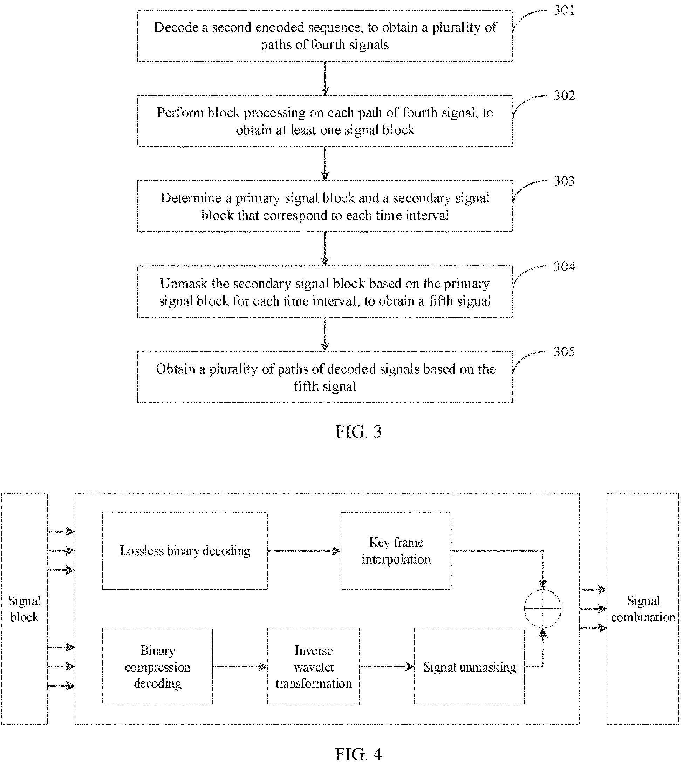

As shown in FIG. 3, this application further provides a haptic signal decoding method, applied to a decoder side. As shown in FIG. 3, the haptic signal decoding method includes:
Step 301: Decode a second encoded sequence, to obtain a plurality of paths of fourth signals.
Step 302: Perform block processing on each path of fourth signal, to obtain at least one signal block, where each signal block corresponds to one time interval.
Step 303: Determine a primary signal block and a secondary signal block that correspond to each time interval.
Step 304: Unmask the secondary signal block based on the primary signal block for each time interval, to obtain a fifth signal, where the fifth signal includes the primary signal block and an unmasked secondary signal block.
Step 305: Obtain a plurality of paths of decoded signals based on the fifth signal.

The second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

Optionally, in some embodiments, the method further includes:
decoding a first encoded sequence, to obtain a key frame sequence, where the first encoded sequence is obtained based on the second signal; and
performing interpolation processing on the key frame sequence, to obtain a sixth signal.

The obtaining a plurality of paths of decoded signals based on the fifth signal includes: performing superposition processing on the fifth signal and the sixth signal, to obtain the plurality of paths of decoded signals.

In this embodiment of this application, the fourth signal may be understood as a high-frequency signal component with a low-frequency residual. Specifically, the decoding a second encoded sequence includes: performing binary decoding and inverse wavelet transformation on the second encoded sequence, to obtain the fourth signal.

Optionally, the superposition processing may include: performing an addition operation.

Optionally, in some embodiments, the unmasking the secondary signal block based on the primary signal block for each time interval, to obtain a fifth signal includes:
for each time interval, unmasking the secondary signal block based on a second masking threshold coefficient corresponding to the secondary signal block, a proportionality coefficient corresponding to the secondary signal block, and an amplitude of the primary signal block, to obtain the fifth signal.

Optionally, in some embodiments, the unmasking includes:
replacing, with M times of a target primary signal, a second secondary signal that needs to be masked in the secondary signal block, where the target primary signal is a primary signal that is in the primary signal block and that is used to mask the second secondary signal, and M is determined based on the second masking threshold coefficient corresponding to the second secondary signal and the proportionality coefficient corresponding to the second secondary signal.

In this embodiment of this application, a value range of M is 0 to 1.

Optionally, in some embodiments, the method further includes:
receiving metadata, where the metadata includes at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

In this embodiment of this application, whether restoration needs to be performed (namely, whether unmasking needs to be performed) may be determined based on the flag in the metadata. When restoration needs to be performed, the corresponding secondary signal block may be unmasked based on the corresponding second masking threshold coefficient, the corresponding proportionality coefficient, and the amplitude of the primary signal block.

Optionally, in some embodiments, the metadata may further include: body area information of all signals, position information in a body area, and relative position information between all the signals. When the haptic signal is a vibration haptic signal, the metadata may further include other information such as a sampling rate of the vibration haptic signal.

It should be noted that after the plurality of paths of decoded signals are obtained, the plurality of paths of decoded signals are matched with the body area and positions in the body area based on the position information in the metadata. The primary signal and the secondary signal also need to be respectively matched to corresponding positions. The primary signal is critical to reproduction of the vibration haptic signal. Reproduction of the primary signal needs to be preferentially ensured. Specifically, the following matching procedure may be included:
1: Match body areas to which all signals belong.
2: Match positions, of several signals that belong to a same body area, in the body area.
3. Add a preference mark to all signals that belongs to the primary signal. The signal to which the preference mark is added is preferentially processed in a subsequent step, to ensure reproduction quality of the vibration haptic signal.

After a matching result is obtained, all paths of signals are transmitted, based on the matching result, to vibration haptic reproduction devices at all positions of a human body that correspond to the signals. Finally, all the vibration haptic reproduction devices receive signals that are delivered by a decoder and that correspond to positions at which the vibration haptic reproduction devices are located. After checking whether the signals match the positions of the devices, the devices complete reproduction of the vibration haptic signal.

To better understand this application, the following describes a decoding procedure in this application with reference to FIG. 4. As shown in FIG. 4, a decoding processing procedure for each path of haptic signal may include the following steps:
41: Perform division into signal blocks, to obtain a first encoded sequence and a second encoded sequence that correspond to each path of haptic signal.
42: Perform lossless binary decoding on the first encoded sequence to obtain a key frame sequence, and perform interpolation processing on the key frame sequence to obtain a sixth signal (namely, a low-frequency signal component).
43: Sequentially perform binary compression decoding, wavelet transformation, and masked signal restoration processing on the second encoded sequence, to obtain a fifth signal.
44: Add a fourth signal and the fifth signal, to obtain one path of decoded signal.
45: Perform signal combination on a plurality of paths of decoded signals, to obtain a final decoded signal.

A haptic signal encoding processing method provided in the embodiments of this application may be performed by a haptic signal encoding processing apparatus. In the embodiments of this application, an example in which the haptic signal encoding processing apparatus performs the haptic signal encoding processing method is used to describe the haptic signal encoding processing apparatus provided in the embodiments of this application.

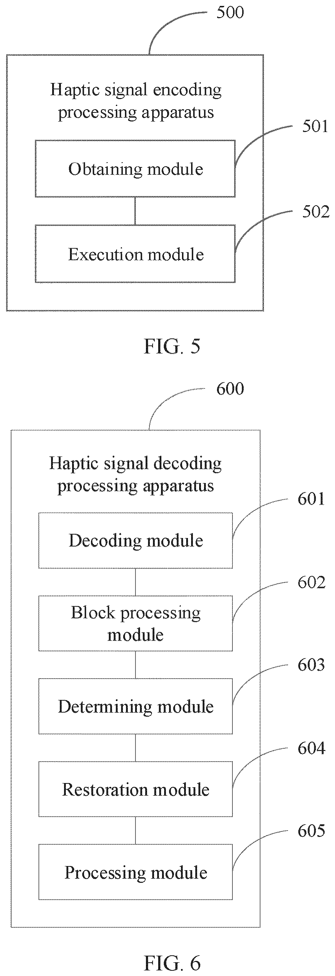

As shown in FIG. 5, an embodiment of this application further provides a haptic signal encoding processing apparatus, applied to an encoder side. As shown in FIG. 5, the haptic signal encoding processing apparatus 500 includes:
an obtaining module 501, configured to obtain at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and
an execution module 502, configured to perform a target operation, where the target operation includes at least one of the following:
   performing first masking processing on the key frame sequence based on a first masking model, and encoding a signal obtained through the first masking processing, to obtain a first encoded sequence; and
   performing second masking processing on the first signal based on a second masking model, and encoding a signal obtained through the second masking processing, to obtain a second encoded sequence.

Optionally, the execution module 502 is specifically configured to perform the following operations:
determining a primary key frame sequence and a secondary key frame sequence from the key frame sequences corresponding to the plurality of paths of haptic signals;
determining the first masking model based on spatial position information corresponding to the primary key frame sequence and spatial position information corresponding to the secondary key frame sequence;
performing first masking processing on the secondary key frame sequence based on the first masking model, to obtain a target key frame sequence, where the target key frame sequence includes the primary key frame sequence and a masked secondary key frame sequence; and
encoding the target key frame sequence, to obtain the first encoded sequence.

Optionally, the execution module 502 is specifically configured to perform the following operations:
inputting a frequency of the primary key frame sequence into the first masking model, to obtain a first masking threshold coefficient;
multiplying an amplitude of the primary key frame sequence by the first masking threshold coefficient, to obtain a first masking threshold matrix; and
performing first masking processing on the secondary key frame sequence based on the first masking threshold matrix, to obtain the target key frame sequence.

Optionally, the primary key frame sequence meets at least one of the following:
the primary key frame sequence is a key frame sequence corresponding to a haptic signal of a haptically sensitive point; and
the primary key frame sequence is a key frame sequence corresponding to a haptic signal whose signal strength is greater than or equal to a preset strength threshold.

Optionally, the execution module 502 is specifically configured to perform the following operations:
performing block processing on each path of first signal, to obtain at least one signal block, where each signal block corresponds to one time interval;
determining a primary signal block and a secondary signal block for a signal block in each time interval;
determining the second masking model based on a spatial-modal mask;
performing second masking processing on the secondary signal block based on the second masking model, to obtain target signal blocks corresponding to each time interval, where the target signal blocks include the primary signal block and a masked secondary signal block;
splicing the target signal blocks corresponding to all time intervals based on a correspondence between a signal block and the haptic signal, to obtain a plurality of paths of to-be-encoded signals; and
performing encoding processing on the plurality of paths of to-be-encoded signals, to obtain the second encoded sequence.

The spatial-modal mask is determined based on a relative position between the primary signal block and the secondary signal block.

Optionally, one primary signal block includes K primary signals, K is a positive integer, and the execution module 502 is specifically configured to perform the following operations:
inputting a characteristic frequency of the primary signal block into the second masking model, to obtain a second masking threshold coefficient;
multiplying an amplitude of the primary signal block by the second masking threshold coefficient, to obtain a second masking threshold matrix;
performing assignment processing on the second masking threshold matrix based on the K primary signals, to obtain a third masking threshold matrix; and
performing second masking processing on the secondary signal block based on the third masking threshold matrix, to obtain the target signal blocks.

The assignment processing meets: performing assignment processing when the K primary signals include at least one unprocessed primary signal; and during a Pth time of assignment processing, assigning a masking threshold of a first position to masking thresholds of n consecutive second positions located after the first position in the second masking threshold matrix, where the first position is adjacent to the n second positions, the first position is a position corresponding to a primary signal with a largest amplitude in an unprocessed primary signal during first (P-1)th times of assignment processing, and a primary signal corresponding to the first position and a primary signal corresponding to the second position are primary signals processed during the Pth time of assignment processing, and both n and P are positive integers.

Optionally, the second masking processing includes at least one of the following:
when an amplitude of a first secondary signal in an Lth secondary signal block is 0, keeping the amplitude of the first secondary signal unchanged, and adding a first flag to metadata, where the first flag is used to indicate that the first secondary signal does not need to be unmasked; and
when an amplitude of a second secondary signal in the Lth secondary signal block is not 0, setting the amplitude of the second secondary signal to 0, and adding a second flag to the metadata, where the second flag is used to indicate that the second secondary signal needs to be unmasked.

L is a positive integer.

Optionally, the haptic signal encoding processing apparatus 500 further includes:
a transform module, configured to perform a fast Fourier transform FFT operation on the primary signal block, to obtain a spectrum of the primary signal block; and
a second determining module, further configured to determine a frequency component with a largest amplitude in the spectrum of the primary signal block as the characteristic frequency of the primary signal block.

Optionally, the haptic signal encoding processing apparatus 500 further includes:
a sending module, configured to send the metadata to a decoder side, where the metadata includes at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

A haptic signal decoding processing method provided in the embodiments of this application may be performed by a haptic signal decoding processing apparatus. In the embodiments of this application, an example in which the haptic signal decoding processing apparatus performs the haptic signal decoding processing method is used to describe the haptic signal decoding processing apparatus provided in the embodiments of this application.

As shown in FIG. 6, an embodiment of this application further provides a haptic signal decoding processing apparatus, applied to a decoder side. As shown in FIG. 6, the haptic signal decoding processing apparatus 600 includes:
a decoding module 601, configured to decode a second encoded sequence, to obtain a plurality of paths of fourth signals;
block processing 602, used to perform block processing on each path of fourth signal, to obtain at least one signal block, where each signal block corresponds to one time interval;
a determining module 603, configured to determine a primary signal block and a secondary signal block that correspond to each time interval;
a restoration module 604, configured to unmask the secondary signal block based on the primary signal block for each time interval, to obtain a fifth signal, where the fifth signal includes the primary signal block and an unmasked secondary signal block; and
a processing module 605, configured to obtain a plurality of paths of decoded signals based on the fifth signal.

The second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

Optionally, the restoration module 604 is specifically configured to: for each time interval, unmask the secondary signal block based on a second masking threshold coefficient corresponding to the secondary signal block, a proportionality coefficient corresponding to the secondary signal block, and an amplitude of the primary signal block, to obtain the fifth signal.

Optionally, the unmasking includes:
replacing, with M times of a target primary signal, a second secondary signal that needs to be masked in the secondary signal block, where the target primary signal is a primary signal that is in the primary signal block and that is used to mask the second secondary signal, and M is determined based on the second masking threshold coefficient corresponding to the second secondary signal and the proportionality coefficient corresponding to the second secondary signal.

Optionally, the haptic signal decoding processing apparatus 600 further includes:
a receiving module 601, configured to receive metadata, where the metadata includes at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

Optionally, the decoding module 601 is further configured to: decode a first encoded sequence, to obtain a key frame sequence. The first encoded sequence is obtained based on the second signal; and perform interpolation processing on the key frame sequence, to obtain a sixth signal.

The processing module 605 is specifically configured to perform superposition processing on the fifth signal and the sixth signal, to obtain the plurality of paths of decoded signals.

The haptic signal encoding processing apparatus or the haptic signal decoding processing apparatus in the embodiments of this application may be an electronic device, for example, an electronic device with an operating system, or may be a component, for example, an integrated circuit or a chip, in an electronic device. The electronic device may be a terminal, or may be another device different from a terminal. For example, the terminal may include but is not limited to the foregoing listed types of the terminal 11. The another device may be a server, a network attached storage (NAS), or the like. This is not specifically limited in this embodiment of this application.

The haptic signal encoding processing apparatus and the haptic signal decoding processing apparatus provided in the embodiments of this application can implement the processes implemented in the method embodiments of FIG. 1 to FIG. 4, and achieve same technical effects. To avoid repetition, details are not described herein again.

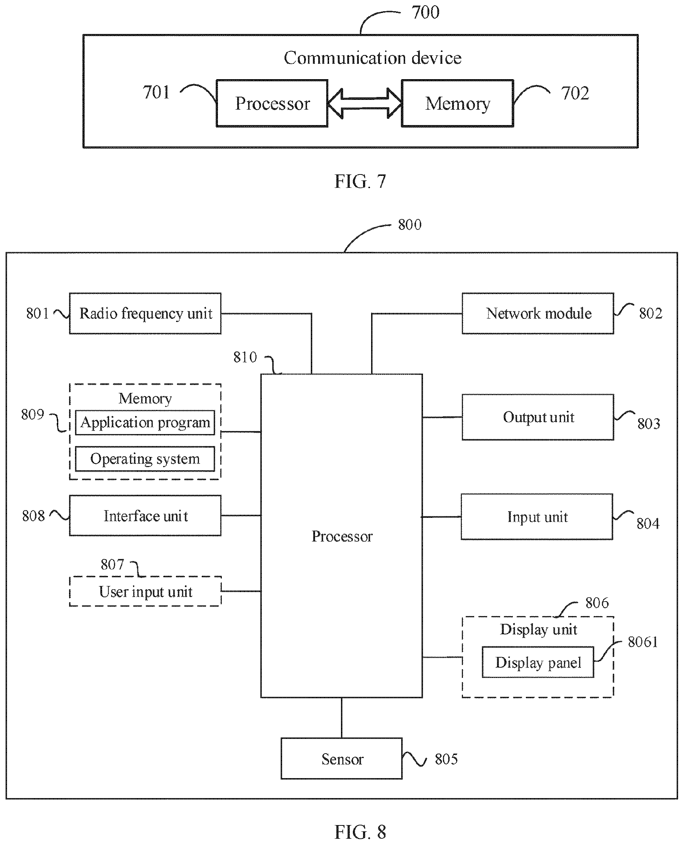

As shown in FIG. 7, an embodiment of this application further provides a communication device 700, including a processor 701 and a memory 702, and the memory 702 stores a program or instructions capable of running on the processor 701. For example, when the communication device 700 is an encoder side device, and the program or the instructions are executed by the processor 701, the steps in the foregoing embodiment of the haptic signal encoding processing method are implemented, and same technical effects can be achieved. When the communication device 700 is a decoder side device, and the program or the instructions are executed by the processor 701, the steps in the foregoing embodiment of the haptic signal decoding processing method are implemented, and same technical effects can be achieved. To avoid repetition, details are not described herein again. Optionally, the memory may further store a time-space joint masking effect model.

An embodiment of this application further provides an electronic device, including a processor and a communication interface. The communication interface is coupled to the processor. The processor is configured to run a program or instructions to implement the steps in the method embodiments shown in FIG. 1 to FIG. 4. The electronic device embodiment corresponds to the foregoing method embodiment. Each implementation process and implementation of the foregoing method embodiment may be applied to the electronic device embodiment, and same technical effects can be achieved. Specifically, FIG. 8 is a schematic diagram of a hardware structure of an electronic device for implementing an embodiment of this application.

The electronic device 800 includes but is not limited to at least some components in a radio frequency unit 801, a network module 802, an output unit 803, an input unit 804, a sensor 805, a display unit 806, a user input unit 807, an interface unit 808, a memory 809, a processor 810, and the like.

A person skilled in the art may understand that the electronic device 800 may further include a power supply (for example, a battery) that supplies power to each component, and the power supply may be logically connected to the processor 810 by using a power management system, to implement functions such as charging management, discharging management, and power consumption management by using the power management system. The structure of the electronic device shown in FIG. 8 constitutes no limitation on the electronic device. The electronic device may include more or fewer components than those shown in the figure, or combine some components, or have different component arrangements. Details are not described herein again.

It should be understood that, in this embodiment of this application, the input unit 804 may include a haptic signal collection sensor and a sensor host computer configured to collect, process, and convert sensor information. The display unit 806 can include a display panel 8061, and the display panel 8061 can be configured in a form of a liquid crystal display, an organic light-emitting diode, or the like. The user input unit 807 includes at least one of a touch panel 8071 or other input devices 8072. The touch panel 8071 is also referred to as a touchscreen. The touch panel 8071 may include two parts: a touch detection apparatus and a touch controller. The other input devices 8072 may include but are not limited to a physical keyboard, a function key (such as a volume control key or an on/off key), a trackball, a mouse, and a joystick. Details are not described herein.

In the embodiments of this application, after receiving downlink data from a network side device, the radio frequency unit 801 may transmit the downlink data to the processor 810 for processing. In addition, the radio frequency unit 801 may send uplink data to the network side device. Generally, the radio frequency unit 801 includes but is not limited to an antenna, an amplifier, a transceiver, a coupler, a low-noise amplifier, a duplexer, and the like.

The memory 809 may be configured to store a software program or instructions and various types of data (for example, which may include data such as a time-space joint masking effect model and a haptic signal). The memory 809 may mainly include a first storage area for storing a program or instructions and a second storage area for storing data. The first storage area may store an operating system, an application program or instructions required by at least one function (for example, a sound playing function or an image playing function), and the like. In addition, the memory 809 may include a volatile memory or a nonvolatile memory. The nonvolatile memory may be a read-only memory (ROM), a programmable read-only memory (PROM), an erasable programmable read-only memory (EPROM), an electrically erasable programmable read-only memory (EEPROM), or a flash memory. The volatile memory may be a random access memory (RAM), a static random access memory (SRAM), a dynamic random access memory (DRAM), a synchronous dynamic random access memory (SDRAM), a double data rate synchronous dynamic random access memory (DDRSDRAM), an enhanced synchronous dynamic random access memory (ESDRAM), a synchlink dynamic random access memory (SLDRAM), and a direct rambus random access memory (DRRAM). The memory 809 in this embodiment of this application includes but is not limited to these memories and any other suitable type of memory.

The processor 810 may include one or more processing units. Optionally, the processor 810 integrates an application processor and a modem processor. The application processor mainly processes operations related to an operating system, a user interface, an application program, and the like. The modem processor mainly processes a wireless communication signal, such as a baseband processor. It may be understood that, the foregoing modem processor may not be integrated into the processor 810.

When the electronic device is an encoder side, the processor 810 is configured to: obtain at least one of a key frame sequence or a first signal that correspond to each of a plurality of paths of haptic signals, where the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and perform a target operation, where the target operation includes at least one of the following: performing first masking processing on the key frame sequence based on a first masking model, and encoding a signal obtained through the first masking processing, to obtain a first encoded sequence; and performing second masking processing on the first signal based on a second masking model, and encoding a signal obtained through the second masking processing, to obtain a second encoded sequence.

When the electronic device is a decoder side, the processor 810 is configured to: decode a second encoded sequence, to obtain a plurality of paths of fourth signals; perform block processing on each path of fourth signal, to obtain at least one signal block, where each signal block corresponds to one time interval; determine a primary signal block and a secondary signal block that correspond to each time interval; unmask the secondary signal block based on the primary signal block for each time interval, to obtain a fifth signal, where the fifth signal includes the primary signal block and an unmasked secondary signal block; and obtain a plurality of paths of decoded signals based on the fifth signal, where the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

It may be understood that for implementation processes of the implementations mentioned in this embodiment, reference may be made to related descriptions in the method embodiment, and same or corresponding technical effects are achieved. To avoid repetition, details are not described herein again.

An embodiment of this application further provides a readable storage medium. The readable storage medium stores a program or instructions. When the program or the instructions are executed by a processor, the processes in the foregoing embodiment of the haptic signal encoding processing method are implemented, or the processes in the foregoing embodiment of the haptic signal decoding processing method are implemented, and same technical effects can be achieved. To avoid repetition, details are not described herein again. Optionally, the readable storage medium may further store a time-space joint masking effect model.

The processor is a processor in the electronic device in the foregoing embodiments. The readable storage medium includes a computer-readable storage medium, such as a computer read-only memory ROM, a random access memory RAM, a magnetic disk, or an optical disc. In some examples, the readable storage medium may be a non-transient readable storage medium.

An embodiment of this application further provides a chip. The chip includes a processor and a communication interface. The communication interface is coupled to the processor. The processor is configured to run a program or instructions to implement the processes in the foregoing embodiments of the haptic signal encoding processing method, or to implement the processes in the foregoing embodiments of the haptic signal decoding processing method, and same technical effects can be achieved. To avoid repetition, details are not described herein again.

It should be understood that the chip mentioned in this embodiment of this application can also be referred to as a system-level chip, a system chip, a chip system, a system on chip, or the like.

An embodiment of this application further provides a computer program/program product. The computer program/program product is stored in a storage medium. The computer program/program product is executed by at least one processor to implement the processes in the foregoing embodiment of the haptic signal encoding processing method or the processes in the foregoing embodiment of the haptic signal decoding processing method, and same technical effects can be achieved. To avoid repetition, details are not described herein again.

An embodiment of this application further provides a haptic signal encoding and decoding system, including an encoder side device and a decoder side device. The encoder side device may be configured to perform the steps of the haptic signal encoding processing method described above, and the decoder side device may be configured to perform the steps of the haptic signal decoding processing method described above.

It should be noted that in this specification, the term "include", "comprise", or any of their variants is intended to cover a non-exclusive inclusion, so that a process, a method, an article, or an apparatus that includes a list of elements not only includes those elements but also includes other elements that are not expressly listed, or further includes elements inherent to such process, method, article, or apparatus. Without more constraints, an element preceded by "includes a ..." does not preclude the existence of additional identical elements in the process, method, article, or apparatus that includes the element. In addition, it should be noted that the scope of the method and apparatus in the implementations of this application is not limited to performing functions in a sequence shown or discussed, and may further include performing functions in a basically simultaneous manner or in a reverse sequence based on related functions. For example, the described method may be performed in an order different from the described order, and various steps may be added, omitted, or combined. In addition, features described with reference to some examples may be combined in other examples.

According to the foregoing descriptions of the implementations, a person skilled in the art may clearly understand that the method in the foregoing embodiments may be implemented by a computer software product and a necessary general-purpose hardware platform, or certainly may be implemented by hardware. The computer software product is stored in a storage medium (such as a ROM, a RAM, a magnetic disk, or an optical disc) and includes several instructions for instructing a terminal or a network side device to perform the methods described in the embodiments of this application.

The foregoing describes the embodiments of this application with reference to the accompanying drawings. However, this application is not limited to the foregoing specific implementations. The foregoing specific implementations are merely illustrative rather than restrictive. Inspired by this application, a person of ordinary skill in the art may develop many forms of implementations without departing from principles of this application and the protection scope of the claims, and all such implementations fall within the protection scope of this application.

## Claims

1. A haptic signal encoding processing method, applied to an encoder side, and comprising:
obtaining at least one of a key frame sequence or a first signal that correspond to each of a plurality of paths of haptic signals, wherein the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and
performing a target operation, wherein the target operation comprises at least one of the following:
performing first masking processing on the key frame sequence based on a first masking model, and encoding a signal obtained through the first masking processing, to obtain a first encoded sequence; and
performing second masking processing on the first signal based on a second masking model, and encoding a signal obtained through the second masking processing, to obtain a second encoded sequence.

2. The method according to claim 1, wherein the performing first masking processing on the key frame sequence based on a first masking model, to obtain a first encoded sequence comprises:
determining a primary key frame sequence and a secondary key frame sequence from the key frame sequences corresponding to the plurality of paths of haptic signals;
determining the first masking model based on spatial position information corresponding to the primary key frame sequence and spatial position information corresponding to the secondary key frame sequence;
performing first masking processing on the secondary key frame sequence based on the first masking model, to obtain a target key frame sequence, wherein the target key frame sequence comprises the primary key frame sequence and a masked secondary key frame sequence; and
encoding the target key frame sequence, to obtain the first encoded sequence.

3. The method according to claim 2, wherein the performing first masking processing on the secondary key frame sequence based on the first masking model, to obtain a target key frame sequence comprises:
inputting a frequency of the primary key frame sequence into the first masking model, to obtain a first masking threshold coefficient;
multiplying an amplitude of the primary key frame sequence by the first masking threshold coefficient, to obtain a first masking threshold matrix; and
performing first masking processing on the secondary key frame sequence based on the first masking threshold matrix, to obtain the target key frame sequence.

4. The method according to claim 2, wherein the primary key frame sequence meets at least one of the following:
the primary key frame sequence is a key frame sequence corresponding to a haptic signal of a haptically sensitive point; and
the primary key frame sequence is a key frame sequence corresponding to a haptic signal whose signal strength is greater than or equal to a preset strength threshold.

5. The method according to any one of claims 1 to 4, wherein the performing second masking processing on the first signal based on a second masking model, and encoding a signal obtained through the second masking processing, to obtain a second encoded sequence comprises:
performing block processing on each path of first signal, to obtain at least one signal block, wherein each signal block corresponds to one time interval;
determining a primary signal block and a secondary signal block for a signal block in each time interval;
determining the second masking model based on a spatial-modal mask;
performing second masking processing on the secondary signal block based on the second masking model, to obtain target signal blocks corresponding to each time interval, wherein the target signal blocks comprise the primary signal block and a masked secondary signal block;
splicing the target signal blocks corresponding to all time intervals based on a correspondence between a signal block and the haptic signal, to obtain a plurality of paths of to-be-encoded signals; and
performing encoding processing on the plurality of paths of to-be-encoded signals, to obtain the second encoded sequence, wherein
the spatial-modal mask is determined based on a relative position between the primary signal block and the secondary signal block.

6. The method according to claim 5, wherein one primary signal block comprises K primary signals, K is a positive integer, and the performing second masking processing on the secondary signal block based on the second masking model, to obtain target signal blocks corresponding to each time interval comprises:
inputting a characteristic frequency of the primary signal block into the second masking model, to obtain a second masking threshold coefficient;
multiplying an amplitude of the primary signal block by the second masking threshold coefficient, to obtain a second masking threshold matrix;
performing assignment processing on the second masking threshold matrix based on the K primary signals, to obtain a third masking threshold matrix; and
performing second masking processing on the secondary signal block based on the third masking threshold matrix, to obtain the target signal blocks, wherein
the assignment processing meets: performing assignment processing when the K primary signals comprise at least one unprocessed primary signal; and during a Pth time of assignment processing, assigning a masking threshold of a first position to masking thresholds of n consecutive second positions located after the first position in the second masking threshold matrix, wherein the first position is adjacent to the n second positions, the first position is a position corresponding to a primary signal with a largest amplitude in an unprocessed primary signal during first (P-1)th times of assignment processing, and a primary signal corresponding to the first position and a primary signal corresponding to the second position are primary signals processed during the Pth time of assignment processing, and both n and P are positive integers.

7. The method according to claim 6, wherein the second masking processing comprises at least one of the following:
when an amplitude of a first secondary signal in an Lth secondary signal block is 0, keeping the amplitude of the first secondary signal unchanged, and adding a first flag to metadata, wherein the first flag is used to indicate that the first secondary signal does not need to be unmasked; and
when an amplitude of a second secondary signal in the Lth secondary signal block is not 0, setting the amplitude of the second secondary signal to 0, and adding a second flag to the metadata, wherein the second flag is used to indicate that the second secondary signal needs to be unmasked, wherein
L is a positive integer.

8. The method according to claim 6, wherein the method further comprises:
performing a fast Fourier transform FFT operation on the primary signal block, to obtain a spectrum of the primary signal block; and
determining a frequency component with a largest amplitude in the spectrum of the primary signal block as the characteristic frequency of the primary signal block.

9. The method according to any one of claims 5 to 8, wherein the method further comprises:
sending the metadata to a decoder side, wherein the metadata comprises at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

10. A haptic signal decoding processing method, applied to a decoder side, and comprising:
decoding a second encoded sequence, to obtain a plurality of paths of fourth signals;
performing block processing on each path of fourth signal, to obtain at least one signal block, wherein each signal block corresponds to one time interval;
determining a primary signal block and a secondary signal block that correspond to each time interval;
unmasking the secondary signal block based on the primary signal block for each time interval, to obtain a fifth signal, wherein the fifth signal comprises the primary signal block and an unmasked secondary signal block; and
obtaining a plurality of paths of decoded signals based on the fifth signal, wherein
the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

11. The method according to claim 10, wherein the unmasking the secondary signal block based on the primary signal block for each time interval, to obtain a fifth signal comprises:
for each time interval, unmasking the secondary signal block based on a second masking threshold coefficient corresponding to the secondary signal block, a proportionality coefficient corresponding to the secondary signal block, and an amplitude of the primary signal block, to obtain the fifth signal.

12. The method according to claim 11, wherein the masking comprises:
replacing, with M times of a target primary signal, a second secondary signal that needs to be masked in the secondary signal block, wherein the target primary signal is a primary signal that is in the primary signal block and that is used to mask the second secondary signal, and M is determined based on the second masking threshold coefficient corresponding to the second secondary signal and the proportionality coefficient corresponding to the second secondary signal.

13. The method according to any one of claims 10 to 12, wherein the method further comprises:
receiving metadata, wherein the metadata comprises at least one of the following:
a position number of the primary signal block and a spatial-modal mask corresponding to the primary signal block;
a model identifier of the second masking model used to perform second masking processing on the first signal;
a flag indicating whether a signal whose amplitude is 0 in the secondary signal block needs to be unmasked; and
a proportionality coefficient of a signal that needs to be masked in the secondary signal block.

14. The method according to any one of claims 10 to 13, wherein the method further comprises:
decoding a first encoded sequence, to obtain a key frame sequence, wherein the first encoded sequence is obtained based on the second signal; and
performing interpolation processing on the key frame sequence, to obtain a sixth signal; and
the obtaining a plurality of paths of decoded signals based on the fifth signal comprises: performing superposition processing on the fifth signal and the sixth signal, to obtain the plurality of paths of decoded signals.

15. A haptic signal encoding processing apparatus, applied to an encoder side, and comprising:
an obtaining module, configured to obtain at least one of a key frame sequence or a first signal that correspond to each of a plurality of paths of haptic signals, wherein the key frame sequence is obtained based on a second signal, the first signal is obtained based on a target residual signal and a third signal, the target residual signal is obtained based on the second signal and the key frame sequence, the second signal and the third signal are obtained by performing low-pass filtering processing on the haptic signal, and a frequency of the second signal is less than a frequency of the third signal; and
an execution module, configured to perform a target operation, wherein the target operation comprises at least one of the following:
performing first masking processing on the key frame sequence based on a first masking model, and encoding a signal obtained through the first masking processing, to obtain a first encoded sequence; and
performing second masking processing on the first signal based on a second masking model, and encoding a signal obtained through the second masking processing, to obtain a second encoded sequence.

16. A haptic signal decoding processing apparatus, applied to a decoder side, and comprising:
a decoding module, configured to decode a second encoded sequence, to obtain a plurality of paths of fourth signals;
a block processing module, configured to perform block processing on each path of fourth signal, to obtain at least one signal block, wherein each signal block corresponds to one time interval;
a first determining module, configured to determine a primary signal block and a secondary signal block that correspond to each time interval;
a restoration module, configured to unmask the secondary signal block based on the primary signal block for each time interval, to obtain a fifth signal, wherein the fifth signal comprises the primary signal block and an unmasked secondary signal block; and
a processing module, configured to obtain a plurality of paths of decoded signals based on the fifth signal, wherein
the second encoded sequence is obtained based on a first signal corresponding to each of a plurality of paths of haptic signals, the first signal is obtained based on a target residual signal and a third signal, the target residual signal is obtained based on a second signal, the second signal and the third signal are obtained by performing low-pass filtering processing on the haptic signal, and a frequency of the second signal is less than a frequency of the third signal.

17. An electronic device, comprising a processor and a memory, wherein the memory stores a program or instructions capable of running on the processor, and when the program or the instructions are executed by the processor, the steps of the haptic signal encoding processing method according to any one of claims 1 to 9 are implemented, or when the program or the instructions are executed by the processor, the steps of the haptic signal decoding processing method according to any one of claims 10 to 14 are implemented.

18. A readable storage medium, wherein the readable storage medium stores a program or instructions, and when the program or the instructions are executed by a processor, the steps of the haptic signal encoding processing method according to any one of claims 1 to 9 are implemented, or the steps of the haptic signal decoding processing method according to any one of claims 10 to 14 are implemented.

19. A chip, wherein the chip comprises a processor and a communication interface, the communication interface is coupled to the processor, and the processor is configured to run a program or instructions, to implement the steps of the haptic signal encoding processing method according to any one of claims 1 to 9, or to implement the steps of the haptic signal decoding processing method according to any one of claims 10 to 14.

20. A computer program/program product, wherein the computer program/program product is stored in a storage medium, and the computer program/program product is executed by at least one processor, to implement the haptic signal encoding processing method according to any one of claims 1 to 9, or to implement the haptic signal decoding processing method according to any one of claims 10 to 14.
